# EUROPEAN PATENT APPLICATION

(11) **EP 4 650 872 A2**
(43) Date of publication of application: **19.11.2025**
(21) Application number: 25205718.7
(22) Date of filing: 30.09.2025
(51) Int. Cl.: G03F 7/00

(54) **AN EXPOSURE APPARATUS AND A METHOD OF PERFORMING A LITHOGRAPHIC EXPOSURE PROCESS**

(71) Applicant: ASML Netherlands B.V., 5500 AH Veldhoven (NL)
(72) Inventor: VAN DEN BRINK, Arie, 5500 AH Veldhoven (NL); WERKMAN, Roy, 5500 AH Veldhoven (NL)
(74) Representative: ASML Netherlands B.V.

(57) **Abstract**

An exposure apparatus configured to perform a lithographic exposure process, comprising an actuator, and a control unit configured to control the actuator, the control unit comprising a trained machine learning model. The control unit is configured to determine, within a predetermined amount of time, a control setting for controlling the actuator by: obtaining a desired correction of the lithographic exposure process; determining an initial control setting for the actuator based on the desired correction of the lithographic exposure process; and iteratively refining the initial control setting to approach the desired correction of the lithographic exposure process, thereby obtaining the control setting for the actuator. The control unit is configured to determine the initial control setting for the actuator by providing the desired correction of the lithographic exposure process as input to the trained machine learning model.

## Description

### FIELD

The present invention relates to the field of lithography and semiconductor manufacturing. The present invention in particular pertains to an exposure apparatus configured to perform a lithographic exposure process, a method of obtaining a trained machine learning mode, a method of determining a control setting for an actuator of an exposure apparatus, and a computer program comprising instructions for performing the methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus comprises several subsystems such as the object stage, the reticle stage, and the projection system. Each of these subsystems comprises actuators that are controlled during a lithographic exposure process performed by the exposure apparatus. The actuation settings of each of the actuators is calculated during the lithographic exposure process. Said calculation of the actuation settings is time-critical, i.e., the actuation settings are calculated within a specified time period. The calculation of the actuation settings may be formulated as a numerical problem with numerous (e.g., hundreds) degrees of freedom that need to be optimized within the imposed time constraint.

On-product performance (overlay, focus, imaging) may suffer in case suboptimal actuation settings are determined within the specified time period. Since actual production conditions differ significantly from set-up conditions, an optimal solution to the numerical problem may not be found within the allotted time period. On-product performance may be reduced and faults may increase by using these calculated suboptimal actuation settings during the lithographic exposure process. It is therefore desirable to increase the accuracy of the calculated actuation settings to be closer to the optimal control settings within an allotted time period, i.e., conforming to an imposed time constraint.

### SUMMARY

It is an object of the invention to overcome certain disadvantages of existing exposure apparatuses (or components thereof) or to at least provide an alternative to said existing apparatuses (or components thereof).

The object of the invention is achieved, according to a first aspect of the invention, by providing an exposure apparatus configured to perform a lithographic exposure process, comprising an actuator and a control unit configured to control the actuator, the control unit comprising a trained machine learning model. The control unit is configured to determine, within a predetermined amount of time, a control setting for controlling the actuator by obtaining a desired correction of the lithographic exposure process; determining an initial control setting for the actuator based on the desired correction of the lithographic exposure process; and iteratively refining the initial control setting to approach the desired correction of the lithographic exposure process, thereby obtaining the control setting for the actuator, a number of iterative refinements constrained by the predetermined amount of time. The control unit is configured to determine the initial control setting for the actuator by providing the desired correction of the lithographic exposure process as input to the trained machine learning model.

In an embodiment, the control unit is configured to control the actuator according to the obtained control setting.

In an embodiment, the control unit further comprises a numerical solver for determining the control setting for the actuator based on a model of the exposure apparatus and a cost function which is based on the desired correction of the lithographic exposure process. The control unit is configured to iteratively refine the initial control setting by providing the initial control setting as an initial condition to the numerical solver. The numerical solver is configured to refine the initial control setting by minimizing the cost function.

Optionally, the control unit is further configured to determine a configuration parameter for the numerical solver by providing the desired correction of the lithographic exposure process to the trained machine learning model; and to initialize the numerical solver with the configuration parameter.

In an embodiment, the control setting comprises a set-point for the actuator, and the initial control setting for the actuator is an initial set-point for the actuator.

In an embodiment, the set-point for the actuator and the initial set-point for the actuator are a dynamically evolving quantity over time.

In an embodiment, the desired correction of the lithographic exposure process comprises one or more of reticle alignment control, reticle heating control, lens heating, wafer heating control, wafer alignment, aberration correction, and on-product overlay control.

In an embodiment, the exposure apparatus comprises a plurality of actuators, and wherein the control unit is configured to determine, within the predetermined amount of time, a control setting for controlling each of the actuators.

Optionally, the exposure apparatus comprises a projection system, the projection system comprising at least one optical element, the plurality of actuators comprises a projection system actuator, and the control unit is configured to control the projection system actuator to manipulate the orientation or deformation of the optical element based on the obtained control setting.

Optionally, the exposure apparatus comprises a support structure arranged to support a patterning device, the plurality of actuators comprises a support structure actuator, and the control unit is configured to control the support structure actuator to manipulate the position of the support structure based on the obtained control setting.

Optionally, the exposure apparatus comprises a substrate stage arranged to hold a substrate, the plurality of actuators comprises a substrate stage actuator, and the control unit is configured to control the substrate stage actuator to manipulate the position of the substrate stage according to the obtained control setting.

In an embodiment, the trained machine learning model is trained by providing a machine learning model with a training dataset, the training dataset comprising an input dataset and an output dataset, wherein the input dataset comprises desired corrections of the lithographic exposure process, and wherein the output dataset comprises, for each desired correction, an associated optimal control setting for the actuator.

Optionally, the machine learning model is a neural network.

Optionally, in embodiments wherein the control unit further comprises the numerical solver for determining the control setting for the actuator, the output dataset is obtained by obtaining, from the numerical solver, respective optimal control settings for the actuator by providing the numerical solver with each correction request in the input dataset, respective optimal control settings correspond to converged numerical solutions computed by the numerical solver.

In an embodiment, the control unit is configured to allocate a predetermined portion of the predetermined amount of time to perform the step of determining the initial control setting for the actuator, and allocate the remainder of the predetermined amount of time to perform the step of iteratively refining the initial control setting.

Optionally, in embodiments wherein the trained machine learning model is trained by providing the machine learning model with the training dataset, the control unit is configured to, after obtaining the control setting for the actuator, update the trained machine learning model using the desired correction of the lithographic exposure process and an associated optimal control setting for the actuator as additional data points in the training dataset of the trained machine learning model.

The object of the invention is achieved, according to a second aspect of the invention, by providing a control unit configured to control an actuator of a semiconductor manufacturing apparatus or semiconductor metrology apparatus configured to perform a process. The control unit comprises a trained machine learning model. The control unit is configured to determine, within a predetermined amount of time, a control setting for controlling the actuator by obtaining a desired correction of the process performed by the semiconductor manufacturing apparatus or semiconductor metrology apparatus; determining an initial control setting for the actuator based on the desired correction of the process performed by the semiconductor manufacturing apparatus or semiconductor metrology apparatus; and iteratively refining the initial control setting to approach the desired correction of the process performed by the semiconductor manufacturing apparatus or semiconductor metrology apparatus, thereby obtaining the control setting for the actuator, a number of iterative refinements constrained by the predetermined amount of time. The control unit is configured to determine the initial control setting for the actuator by providing the desired correction of the process performed by the semiconductor manufacturing apparatus or semiconductor metrology apparatus as input to the trained machine learning model.

The object of the invention is achieved, according to a third aspect of the invention, by providing a method of obtaining a trained machine learning model, the method comprising the following steps: collecting an input dataset comprising a plurality of desired corrections of a lithographic exposure process performed by an exposure apparatus; constructing an output dataset; and training a machine learning model using the input dataset and the output dataset, thereby obtaining the trained machine learning model. The output dataset is constructed by, for each of desired correction of the lithographic exposure in the plurality of desired corrections of the lithographic exposure: determining an initial estimate of the control setting for an actuator of the lithographic exposure apparatus based on the desired correction of the lithographic exposure process; iteratively refining the initial control setting to approach the desired correction of the lithographic exposure process, thereby obtaining an optimal control setting for the actuator and adding the optimal control setting for the actuator to the output dataset.

The object of the invention is achieved, according to a fourth aspect of the invention, by providing a method of determining, within a predetermined amount of time, a control setting for an actuator of an exposure apparatus based on a desired correction of a lithographic exposure process performed by the exposure apparatus. The method comprises the steps of determining an initial control setting for the actuator based on the desired correction of the lithographic exposure process by providing the desired correction of the lithographic exposure process as input to a trained machine learning model; and iteratively refining the initial control setting to approach the desired correction of the lithographic exposure process, thereby obtaining the control setting for the actuator, a number of iterative refinements constrained by the predetermined amount of time. The trained machine learning model is for example obtained by the method according to the third aspect of the invention.

The object of the invention is achieved, according to a third aspect of the invention, by providing a method performed by an exposure apparatus comprising projecting a patterned beam of radiation onto a substrate, wherein a control setting for an actuator of the exposure apparatus is determined by a method according to the fourth aspect of the invention.

The object of the invention is achieved, according to a sixth aspect of the invention, by providing a computer program comprising instructions to cause a computer or the control unit of the exposure apparatus according to the first aspect of the invention or the control unit according to the second aspect of the invention to perform the steps of the method according to the third aspect of the invention.

The object of the invention is achieved, according to a sixth aspect of the invention, by providing a computer program comprising instructions to cause the control unit of the exposure apparatus according to the first aspect of the invention or the control unit according to the second aspect of the invention to perform the steps of the method according to the fourth aspect of the invention or the fifth aspect of the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts components involved in determining a control setting for an actuator of the lithographic apparatus according to an embodiment of the invention.
- Figure 3 is a flowchart schematically depicting the steps of a method of determining, within a predetermined amount of time, a control setting for an actuator of an exposure apparatus, the method being performed by a control unit of the lithographic apparatus according to an embodiment of the invention.
- Figure 4 depicts components involved in obtaining a trained machine learning model.
- Figure 5 is a flowchart schematically depicting the steps of a method of obtaining the trained machine learning model.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The invention will be explained in more detail below with reference to drawings in which illustrative embodiments thereof are shown. The drawings are intended exclusively for illustrative purposes and not as a restriction of the inventive concept which is to cover all modifications, equivalents, and alternatives falling within the scope of the present invention. The scope of the invention is only limited by the definitions presented in the appended claims.

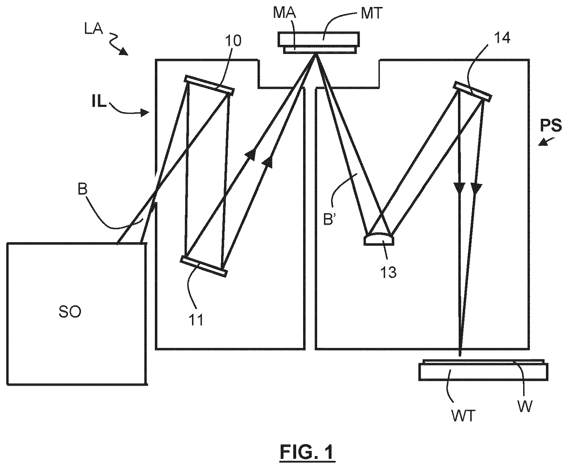

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL configured to condition a radiation beam B (e.g., UV radiation, DUV radiation or EUV radiation), a support structure MT configured to support a patterning device MA (e.g., a mask), a projection system PS and a substrate table WT configured to support a substrate W.

The illumination system IL is configured to condition the EUV radiation beam B before the radiation beam B is incident upon the patterning device MA. The illumination system IL may include various types of optical components, such as refractive, reflective, magnetic, electromagnetic, electrostatic, and/or other types of optical components, or any combination thereof, for directing, shaping, and/or controlling radiation. The illumination system IL may include a facetted field mirror device 10 and a facetted pupil mirror device 11. The faceted field mirror device 10 and faceted pupil mirror device 11 together provide an EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the (e.g., EUV) radiation beam B interacts with the patterning device MA. As a result of this interaction, a patterned (e.g., EUV) radiation beam B' is generated. The projection system PS is configured to project the patterned (e.g., EUV) radiation beam B' onto the substrate W. For that purpose, the projection system PS may comprise a plurality of mirrors 13,14 which are configured to project the patterned (e.g., EUV) radiation beam B' onto the substrate W held by the substrate table WT. The projection system PS may apply a reduction factor to the patterned (e.g., EUV) radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned (e.g., EUV) radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Lithographic apparatus LA is configured to perform a lithographic exposure process as described above. The lithographic apparatus LA, or a component of the lithographic apparatus LA, such as a control unit of the lithographic apparatus LA, is configured to control actuators of the lithographic apparatus LA during the lithographic exposure process. Examples of such actuators include actuators that manipulate one or more components of the lithographic exposure apparatus LA such as the projection system PS, mask table MT (also called a support structure, which is arranged to support a patterning device, e.g., mask MA), and the substrate stage which includes substrate table WT. During the lithographic exposure process, the control unit determines control values/settings, e.g., setpoints, for the actuators to perform the lithographic exposure process. The control unit is for example in (direct or indirect) communication with the actuators. The control unit may be configured to control the actuators according to the determined control values by, e.g., supplying the control values as signals to the actuators. Examples of control settings include a routing order for a plurality of fields to be exposed across a substrate, a setpoint for lens manipulators, and paths (changes in position) of the mask table MT or substrate table WT.

The control unit is configured to determine the control settings for the actuators within a predetermined amount of time. The control unit is thus configured to determine an acceptable control setting in real-time, meaning that the computation time is limited by a real-time deadline. The real-time deadline thus specifies a predefined time period in which the acceptable control setting is to be determined, which may be imposed by a throughput requirement of the lithographic apparatus or by an allotted time in between field exposures of a substrate. The predetermined amount of time is typically between 10-100ms, for example 50ms.

During the lithographic exposure process, a set of correction requests may be determined. The correction requests are a combination or set of various effects which occur during the lithographic exposure process and may affect said lithographic exposure process. For example, the correction requests relate to lens heating, reticle heating, or wafer deformation. The desired correction may comprise one or more of reticle alignment control, reticle heating control, lens heating, wafer heating control, wafer alignment, aberration correction, and on-product overlay control. These effects may occur in a production setting due to imperfections in the components of the lithographic apparatus, heating control loops, or customer requests. A sum of the set of correction requests may be referred to as a desired correction. The total sum of correction requests may, e.g., be performed on a dense optimization grid by converting (analytical) model parameters to the (numerical) grid.

The control unit is for example configured to determine, within the predetermined amount of time, a control setting for controlling an actuator of the lithographic exposure apparatus by obtaining the desired correction of the lithographic exposure process. determining an initial control setting for the actuator based on the desired correction of the lithographic exposure process and iteratively refining the initial control setting to approach the desired correction of the lithographic exposure process, thereby obtaining the control setting for the actuator. The number of iterative refinements is constrained by the predetermined amount of time. For example, if the predetermined amount of time is 50ms and a single iteration is associated with a duration of 1ms, the maximum number of iterations is 50. Thus, the control unit iteratively determines a solution to a numerical problem, wherein the numerical problem is defined by the desired correction as well as the properties of the lithographic apparatus LA which may include properties of the actuators of the lithographic apparatus LA and/or properties related to components of the lithographic apparatus LA involved in the lithographic exposure process.

Since production conditions may differ from conditions at manufacture of the lithographic device due to the correction requests, the control unit may not be able to determine optimal control settings for the actuators to account for the correction requests. An optimal control setting may for example by a converged solution to the numerical problem. If convergence cannot be achieved within the predetermined amount of time, the determined control settings may be non-optimal. In addition or alternatively, in case the solution space for the numerical problem is non-convex, the numerical solution to the numerical problem as determined by the numerical solver may correspond to a local minimum which may represent a non-optimal solution.

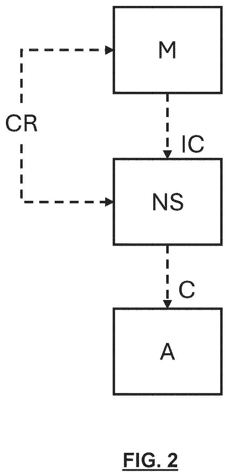

Fig. 2 depicts (virtual) components involved in determining a control setting for an actuator A of the lithographic apparatus according to an embodiment of the invention. A control unit - the control unit for example being the control unit of lithographic apparatus LA, of a semiconductor manufacturing apparatus, or of a semiconductor metrology apparatus - comprises a numerical solver NS which is configured to determine control setting C for actuator A based on a set of correction requests CR, i.e., a desired correction. The desired correction may relate to a process performed by the lithographic apparatus LA (such as a lithographic exposure process) or to a process performed by a semiconductor manufacturing apparatus or semiconductor metrology apparatus. The numerical solver NS may be run in "real-time mode", in which the numerical solver NS is configured to determine the control setting C within the predetermined time period. The numerical solver NS may alternatively be run in "non-real-time mode", in which the numerical solver NS is configured to determine an optimal control setting C without time constraint or within a time period which is longer than the predetermined time period. In production, e.g., during a lithographic exposure process or during a metrology-related process, the numerical solver NS is run in real-time mode.

The numerical solver NS is configured to iteratively refine an initial control setting IC, also called an "initial condition" to obtain a refined control setting C. In production settings, in some cases the refined control setting C corresponds to the optimal control setting. In many cases, however, refined control setting C is not equal to the optimal control setting. Rather, the refined control setting C is an approximation of the optimal control setting. The initial control setting may be seen as an initial approximation of the optimal control setting. In case the initial approximation is a good approximation of the optimal control setting (i.e., the initial approximation and the optimal control setting are close), then the numerical solver is more likely to converge and/or the numerical solution determined by the numerical solver may be closer to the optimal control setting. For example, the determined numerical solution represents a global minimum or a better local minimum. This means that the refined control setting will also be closer to the optimal control setting. Therefore, the determining of an accurate initial control setting IC may contribute to the convergence of the numerical solver, and, therefore, to the optimality of the refined control setting C.

The numerical solver NS may be configured to refine the initial controls setting C based on a model of the lithographic apparatus LA and a cost function which is based on the desired correction of the lithographic exposure process. In alternative embodiments, the control setting C relates to an actuator of a semiconductor manufacturing apparatus or semiconductor metrology apparatus and is based on a model of said semiconductor manufacturing apparatus or semiconductor metrology apparatus. The model of the lithographic apparatus LA (or of the semiconductor manufacturing apparatus or semiconductor metrology apparatus) may for example be a system of non-linear equations and may, among others, comprise a lens manipulator model, which describes the shape of the image ending up on the wafer as a function of, e.g., the movement of different lens elements within the lens. Other parts of the model may for example relate to the movement of the substrate table WT and the mask table MT. The cost function defines an error value which may be seen as a fitting error to achieve the desired correction of the lithographic exposure process. The numerical solver is configured to refine the initial control setting by minimizing the cost function. The cost function therefore may be able to determine controls settings for one or more actuators of the lithographic apparatus LA, wherein the control settings are associated with the degrees of freedom of control of the actuators. An example of such a degree of freedom is a setpoint for a lens manipulator which manipulates e.g. the orientation of the lens or a setpoint for a substrate stage actuator which manipulates e.g., the position of the substrate table WT and/or of the substrate W.

For example, the control setting may relate to a lens actuator or a stage actuator in the lithographic apparatus LA or in a metrology apparatus, wherein the control unit is configured to control the respective actuator according to the obtained control setting. The control setting may relate to further actuators which are used to implement a lithographic exposure process or any other time-critical process performed by the lithographic apparatus LA/the metrology apparatus. The control setting may result in a desired correction to be applied to the lithographic exposure process, which therefore may improve the result of the lithographic exposure process. The control setting for example is a setpoint of one or more lens manipulators configured to apply deformations to a lens in order to control the lens. These setpoints are based on the desired correction for the lithographic exposure process as calculated by the numerical solver. The set-point for the actuator and the initial set-point for the actuator may be dynamically evolving quantities over time. Thus, the set-point is for example a trajectory of an actuator, such as for example the dynamically evolving position or orientation of the actuator. The set-point thus represents the behavior of the actuator(s) of the lithographic apparatus LA in order to perform the lithographic exposure process.

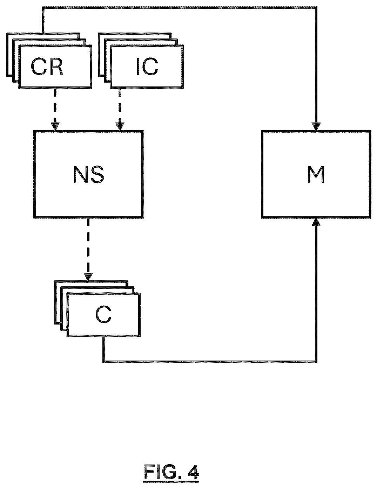

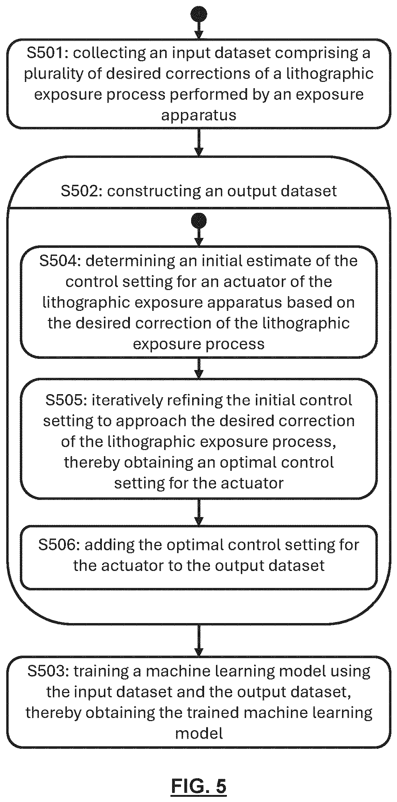

The control unit further comprises a trained machine learning model M. The machine learning model M is for example a neural network. The trained machine learning model M is configured to provide, based on a desired correction of the lithographic exposure apparatus, an initial control setting for the actuator. The trained machine learning model M is obtained by training a machine learning model on a dataset with a plurality of desired corrections of the lithographic exposure process and a plurality of associated actuator settings. These actuator settings in the training data set are calculated by the numerical solver in "non-real-time", i.e., at system setup by allowing the numerical solver to converge to an optimal solution, or at least by allowing the numerical solver to obtain a solution in a longer time period than the predetermined amount of time. The training method for obtaining the trained machine learning model M is explained in more detail below with reference to Figs. 4 and 5.

The trained machine learning model M has learned from a large set of use cases to provide an initial control setting for the actuator based on a desired correction of the lithographic exposure process. The trained machine learning model M may thus be seen as an approximation of the numerical solver NS itself. In other words, the trained machine learning model M is able to compute within a certain degree of accuracy a solution to the numerical problem defined by the desired correction CR. Thus, the initial control setting IC computed by the machine learning model M may represent an approximation of the optimal control setting. Therefore, the initial control setting IC may represent a more accurate initial condition of the numerical solver NS. By using the machine learning model M to compute the initial control setting IC, the accuracy of the refined control setting C computed by the numerical solver NS may be increased.

In a variant, the trained machine learning model M is not comprised by the control unit. Rather, the trained machine learning model M may be stored outside of the lithographic apparatus LA on an external component. The control unit of the lithographic apparatus LA may be in communication with the external component to obtain the initial control setting IC from the trained machine learning model M.

The machine learning model M may, in a relatively short time, compute an initial approximation of the solution (i.e., the control setting C) which is computed by the numerical solver NS. The control unit may be configured to allocate a predetermined portion of the predetermined amount of time to perform the step of determining the initial control setting for the actuator. The predetermined portion may be in the range of 5-20% of the total predetermined amount of time, for example 10% of the total predetermined amount of time. The control unit is further configured to allocate the remainder of the predetermined amount of time (e.g., 80-95%, for example 90%) to perform the step of iteratively refining the initial control setting. As a result, a small amount of the predetermined amount of time which is allocated for determining the control setting C is used to determine the initial control setting IC, which may contribute to increasing the accuracy of the determined control setting. Therefore, according to the invention, smart initialization of the numerical solver may contribute to increasing the accuracy of the end result, i.e., contribute to a more accurate obtained control setting for the actuator. An increased accuracy of the control settings may contribute to improving on-product performance. The advantage of the invention may be achieved in time-critical control of an actuator of a lithography apparatus, of a semiconductor manufacturing apparatus or semiconductor metrology apparatus. The processes performed by these apparatus may be improved due to faster and/or more accurate initialization of the numerical solver NS.

In a variant, the machine learning model may be configured to provide, instead of or in addition to the initial control setting C, a solver setting to the numerical solver NS. The solver setting (i.e., configuration parameter) is for example a hyperparameter used during the numerical solving of the numerical problem. The solver setting is for example an initial step size of the numerical solver NS. In this variant, the control unit is further configured to determine the configuration parameter for the numerical solver NS by providing the desired correction of the lithographic exposure process to the trained machine learning model M and to initialize the numerical solver NS with the configuration parameter.

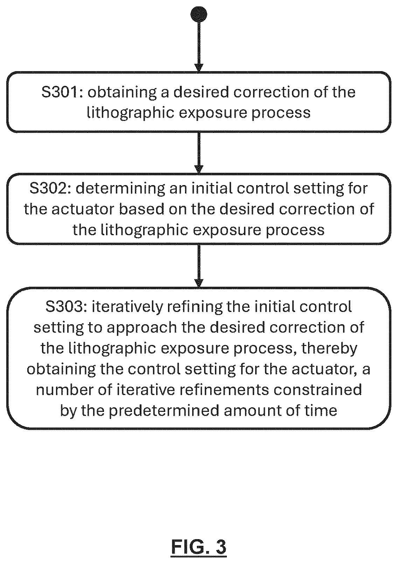

The steps of a method of determining, within a predetermined amount of time, a control setting for an actuator of an exposure apparatus based on a desired correction of a lithographic exposure process performed by the exposure apparatus, are shown schematically in Fig. 3. This method may be performed by the control unit of the lithographic apparatus LA.

In step S301, a desired correction of the lithographic exposure process is obtained.

In step S302, an initial control setting for the actuator is determined based on the desired correction of the lithographic exposure process. The initial control setting for the actuator is obtained by providing the desired correction of the lithographic exposure process as input to the trained machine learning model M. The trained machine learning model M is configured to return, upon being provided with the desired correction, the initial control setting for the actuator A.

In step S303, the initial control setting is iteratively refined, e.g., by the numerical solver NS, to approach the desired correction of the lithographic exposure process. Therewith, the control setting for the actuator A is obtained. In other words, the control setting is iteratively refined starting from the initial control setting. To approach the desired correction of the lithographic exposure process, the control setting for the actuator A is determined such that, in certain cases, the actuator is controlled in order to account for a set of (expected) disturbances or distortions that occur in the lithographic apparatus LA during the lithographic exposure process. To approach the desired correction, the obtained control setting for the actuator is determined such that these (expected) disturbances or distortions are reduced or eliminated. A number of iterative refinements is constrained by the predetermined amount of time, i.e., the numerical solver is run in "real-time".

In an embodiment, the exposure apparatus comprises a plurality of actuators, and a control setting for controlling each of the actuators is determined within the predetermined amount of time.

The invention also relates to a computer program which comprises instructions to cause a computer or the control unit of the lithographic apparatus LA to perform the method of determining, within a predetermined amount of time, a control setting for an actuator A of the lithographic apparatus LA based on a desired correction of a lithographic exposure process performed by the lithographic apparatus LA as described above.

Fig. 4 depicts (virtual) components involved in obtaining trained machine learning model M.

The numerical solver NS is used for training the model M. The training is performed off-line, e.g., while the lithographic machine LA is idle (i.e., not performing a lithographic exposure process), or wholly separate from the lithographic machine LA, for example based on a model of the lithographic machine LA. Therefore, for training the model M, the numerical solver NS is run in "non-real-time" mode in which the numerical solver NS is allowed to find a better local minimum or the actual global minimum (based on the cost function).

A plurality of desired corrections CR of the lithographic exposure process is used as input to the numerical solver NS. For each desired correction CR, an initial control setting IC is also provided. Said initial control setting IC may be computed by known techniques for initializing numerical solvers. For each desired correction CR, the numerical solver NS iteratively refines the initial control setting IC to obtain a refined control setting C.

The plurality of desired corrections CR together with the obtained refined control settings C are used as a training set for obtaining the trained machine learning model M, for example in a method as explained below with reference to Fig. 5.

The steps of a (computer-implemented) method of obtaining a trained machine learning model are shown schematically in Fig. 5. This method may be performed by the control unit of the lithographic apparatus LA. Alternatively, these steps may be performed by resources outside of the lithographic apparatus LA, for example using specialized computing resources. Such resources may include servers, clusters of general-purpose processors, graphics processing units (GPUs), tensor processing units (TPUs), field-programmable gate arrays (FPGAs), application-specific integrated circuits (ASICs), or cloud-based machine learning platforms. The components shown in Fig. 4 may therefore be deployed either directly on the lithographic apparatus LA or on the resources outside of the lithographic apparatus LA used for training the machine learning model M.

In step S501, an input dataset comprising a plurality of desired corrections of a lithographic exposure process performed by an exposure apparatus is collected.

In step S502, an output dataset is constructed. Step S502 comprises three sub-steps. In the first sub-step S504, an initial estimate of the control setting for an actuator of the lithographic exposure apparatus based on the desired correction of the lithographic exposure process is determined. In the second sub-step S505, the initial control setting is refined to approach the desired correction of the lithographic exposure process, thereby obtaining an optimal control setting for the actuator. In the third sub-step S506, the optimal control setting for the actuator is added to the output dataset.

The input dataset and the output dataset together form the training dataset for the machine learning model M.

In step S503, the machine learning model is trained using the training dataset comprising the input dataset and the output dataset. The machine learning model may be iteratively updated based on the training dataset so as to minimize an error metric or loss function, thereby improving the ability of the model to predict outcomes for previously unseen inputs. Additional use cases each comprising a desired correction of the lithographic exposure process and an associated optimal control setting for one or more actuators may be added to the training dataset over time. Therewith, the training dataset evolves over time which may further contribute to the machine learning model, being trained on said training dataset which evolves over time, determining a more accurate initial estimate of the control setting.

The training process may employ an iterative optimization algorithm, such as gradient descent or a variant thereof, to adjust the parameters of the machine learning model. During each iteration, the model receives an input sample and generates a predicted output. The predicted output is compared to the expected output, and the difference is quantified as an error signal. Based on the error signal, the model parameters are updated in a direction that reduces the error. Over successive iterations, the model converges toward a set of parameters that provide improved predictive performance.

The machine learning model may be trained using supervised learning techniques. In supervised learning, the training data comprises pairs of input features and corresponding target outputs that represent desired outcomes - in other words, the training data comprises the input dataset and the output dataset described above. The model generates a predicted output for each input and compares the predicted output to the target output. An error value is determined based on the difference between the predicted and target outputs. The model parameters are then iteratively adjusted through an optimization process to reduce the error across the training set.

The machine learning model may for example be a neural network comprising an input layer, one or more hidden layers, and an output layer. Each layer includes a plurality of nodes connected by weighted links. During training, the weights associated with the links are adjusted through a backpropagation process that propagates the error signal from the output layer toward the input layer. The adjustment of weights is performed in accordance with an optimization routine that seeks to minimize a predefined loss function, such as mean squared error, cross-entropy loss, or another suitable metric.

To evaluate training effectiveness, the data may be partitioned into training, validation, and testing subsets. The training subset is used to fit the model, while the validation subset is used to tune hyperparameters, detect overfitting, and guide early stopping criteria. The testing subset provides an independent measure of model performance after training is completed. This partitioning ensures that the machine learning model achieves reliable performance when applied to new, unseen data reflective of customer use cases.

Optionally, the machine learning model M is updated, i.e., as an optional step in the method as explained above with reference to Fig. 3. The machine learning model may be updated or retrained using newly obtained training data. The control unit may be configured to detect that the desired correction of the lithographic exposure is far removed from the correction requests used in the training dataset for training the machine learning model M. The control unit may be configured to flag said desired correction. The control unit may further be configured to obtain from the numerical solver a refined control setting for the flagged desired correction(s). The numerical solver in this case can be operated in real-time or non-real-time mode. Updating the machine learning model M may involve retraining the model from scratch using the training dataset augmented with the flagged desired correction(s) and their associated computed control settings, or alternatively incremental learning may be performed in which the model parameters of machine learning model M are adjusted based only on the flagged desired correction(s) and their associated computed control settings.

The invention also relates to a computer program which comprises instructions to cause a computer or the control unit of the lithographic apparatus LA to perform the method of obtaining a trained machine learning model as described above.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, control units, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Further, this document describes the following clauses of the present invention:
1. An exposure apparatus configured to perform a lithographic exposure process, comprising:
   - an actuator;
   - a control unit configured to control the actuator, the control unit comprising a trained machine learning model;
      wherein the control unit is configured to determine, within a predetermined amount of time, a control setting for controlling the actuator by:
         - obtaining a desired correction of the lithographic exposure process;
         - determining an initial control setting for the actuator based on the desired correction of the lithographic exposure process;
         - iteratively refining the initial control setting to approach the desired correction of the lithographic exposure process, thereby obtaining the control setting for the actuator, a number of iterative refinements constrained by the predetermined amount of time;
      wherein the control unit is configured to determine the initial control setting for the actuator by providing the desired correction of the lithographic exposure process as input to the trained machine learning model.
2. The exposure apparatus according to clause 1, wherein the control unit is configured to control the actuator according to the obtained control setting.
3. The exposure apparatus according to any one of the preceding clauses, wherein:
   - the control unit further comprises a numerical solver for determining the control setting for the actuator based on a model of the exposure apparatus and a cost function which is based on the desired correction of the lithographic exposure process;
   - the control unit is configured to iteratively refine the initial control setting by providing the initial control setting as an initial condition to the numerical solver; and
   - the numerical solver is configured to refine the initial control setting by minimizing the cost function.
4. The exposure apparatus according to clause 3, wherein the control unit is further configured to:
   - determine a configuration parameter for the numerical solver by providing the desired correction of the lithographic exposure process to the trained machine learning model;
   - initialize the numerical solver with the configuration parameter.
5. The exposure apparatus according to any one of the preceding clauses, wherein the control setting comprises a set-point for the actuator, and wherein the initial control setting for the actuator is an initial set-point for the actuator.
6. The exposure apparatus according to any one of the preceding clauses, wherein the set-point for the actuator and the initial set-point for the actuator are a dynamically evolving quantity over time.
7. The exposure apparatus according to any one of the preceding clauses, wherein the desired correction of the lithographic exposure process comprises one or more of reticle alignment control, reticle heating control, lens heating, wafer heating control, wafer alignment, aberration correction, and on-product overlay control.
8. The exposure apparatus according to any one of the preceding clauses, wherein the exposure apparatus comprises a plurality of actuators, and wherein the control unit is configured to determine, within the predetermined amount of time, a control setting for controlling each of the actuators.
9. The exposure apparatus according to clause 8, wherein:
   - the exposure apparatus comprises a projection system, the projection system comprising at least one optical element;
   - the plurality of actuators comprises a projection system actuator; and
   - the control unit is configured to control the projection system actuator to manipulate the orientation or deformation of the optical element based on the obtained control setting.
10. The exposure apparatus according to any one of clauses 8-9, wherein:
   - the exposure apparatus comprises a support structure arranged to support a patterning device;
   - the plurality of actuators comprises a support structure actuator; and
   - the control unit is configured to control the support structure actuator to manipulate the position of the support structure based on the obtained control setting.
11. The exposure apparatus according to any one of clauses 8-10, wherein:
   - the exposure apparatus comprises a substrate stage arranged to hold a substrate;
   - the plurality of actuators comprises a substrate stage actuator; and
   - the control unit is configured to control the substrate stage actuator to manipulate the position of the substrate stage according to the obtained control setting.
12. The exposure apparatus according to any one of the preceding clauses, wherein the trained machine learning model is trained by providing a machine learning model with a training dataset, the training dataset comprising an input dataset and an output dataset, wherein the input dataset comprises desired corrections of the lithographic exposure process, and wherein the output dataset comprises, for each desired correction, an associated optimal control setting for the actuator.
13. The exposure apparatus according to clause 12, wherein the machine learning model is a neural network.
14. The exposure apparatus according to any one of clauses 12-13 and clause 3, wherein the output dataset is obtained by obtaining, from the numerical solver, respective optimal control settings for the actuator by providing the numerical solver with each correction request in the input dataset, respective optimal control settings correspond to converged numerical solutions computed by the numerical solver.
15. The exposure apparatus according to any one of the preceding clauses, wherein the control unit is configured to:
   - allocate a predetermined portion of the predetermined amount of time to perform the step of determining the initial control setting for the actuator, and
   - allocate the remainder of the predetermined amount of time to perform the step of iteratively refining the initial control setting.
16. The exposure apparatus according to any one of clauses 12-15, wherein the control unit is configured to, after obtaining the control setting for the actuator, update the trained machine learning model using the desired correction of the lithographic exposure process and an associated optimal control setting for the actuator as additional data points in the training dataset of the trained machine learning model.
17. A control unit configured to control an actuator of a semiconductor manufacturing apparatus or semiconductor metrology apparatus configured to perform a process, the control unit comprising a trained machine learning model;
   wherein the control unit is configured to determine, within a predetermined amount of time, a control setting for controlling the actuator by:
      - obtaining a desired correction of the process performed by the semiconductor manufacturing apparatus or semiconductor metrology apparatus;
      - determining an initial control setting for the actuator based on the desired correction of the process performed by the semiconductor manufacturing apparatus or semiconductor metrology apparatus;
      - iteratively refining the initial control setting to approach the desired correction of the lithographic process performed by the semiconductor manufacturing apparatus or semiconductor metrology apparatus, thereby obtaining the control setting for the actuator, a number of iterative refinements constrained by the predetermined amount of time;
   wherein the control unit is configured to determine the initial control setting for the actuator by providing the desired correction of the process performed by the semiconductor manufacturing apparatus or semiconductor metrology apparatus as input to the trained machine learning model.
18. The control unit according to clause 17, wherein the control unit is configured to control the actuator according to the obtained control setting.
19. The control unit according to any one of clauses 17-18, wherein:
   - the control unit further comprises a numerical solver for determining the control setting for the actuator based on a model of the exposure apparatus and a cost function which is based on the desired correction of the process performed by the semiconductor manufacturing apparatus or semiconductor metrology apparatus;
   - the control unit is configured to iteratively refine the initial control setting by providing the initial control setting as an initial condition to the numerical solver; and
   - the numerical solver is configured to refine the initial control setting by minimizing the cost function.
20. The control unit according to clause 19, wherein the control unit is further configured to:
   - determine a configuration parameter for the numerical solver by providing the desired correction of the process performed by the semiconductor manufacturing apparatus or semiconductor metrology apparatus to the trained machine learning model;
   - initialize the numerical solver with the configuration parameter.
21. The control unit according to any one of clauses 17-20, wherein the control setting comprises a set-point for the actuator, and wherein the initial control setting for the actuator is an initial set-point for the actuator.
22. The control unit according to any one of clauses 17-21, wherein the set-point for the actuator and the initial set-point for the actuator are a dynamically evolving quantity over time.
23. The control unit according to any one of clauses 17-22, and wherein the control unit is configured to determine, within the predetermined amount of time, a control setting for controlling each of a plurality of actuators.
24. The control unit according to any one of clauses 17-23, wherein the trained machine learning model is trained by providing a machine learning model with a training dataset, the training dataset comprising an input dataset and an output dataset, wherein the input dataset comprises desired corrections of the process performed by the semiconductor manufacturing apparatus or semiconductor metrology apparatus, and wherein the output dataset comprises, for each desired correction, an associated optimal control setting for the actuator.
25. The control unit according to clause 24, wherein the machine learning model is a neural network.
26. The control unit according to any one of clauses 24-25 and clause 19, wherein the output dataset is obtained by obtaining, from the numerical solver, respective optimal control settings for the actuator by providing the numerical solver with each correction request in the input dataset, respective optimal control settings correspond to converged numerical solutions computed by the numerical solver.
27. The control unit according to any one of the clauses 24-26, wherein the control unit is configured to:
   - allocate a predetermined portion of the predetermined amount of time to perform the step of determining the initial control setting for the actuator, and
   - allocate the remainder of the predetermined amount of time to perform the step of iteratively refining the initial control setting.
28. The control unit according to any one of claims 24-27, wherein the control unit is configured to, after obtaining the control setting for the actuator, update the trained machine learning model using the desired correction of the process performed by the semiconductor manufacturing apparatus or semiconductor metrology apparatus and an associated optimal control setting for the actuator as additional data points in the training dataset of the trained machine learning model.
29. A method of obtaining a trained machine learning model, the method comprising the following steps:
   - collecting an input dataset comprising a plurality of desired corrections of a lithographic exposure process performed by an exposure apparatus;
   - constructing an output dataset by, for each of desired correction of the lithographic exposure in the plurality of desired corrections of the lithographic exposure:
      - determining an initial estimate of the control setting for an actuator of the lithographic exposure apparatus based on the desired correction of the lithographic exposure process;
      - iteratively refining the initial control setting to approach the desired correction of the lithographic exposure process, thereby obtaining an optimal control setting for the actuator;
      - adding the optimal control setting for the actuator to the output dataset;
   - training a machine learning model using the input dataset and the output dataset, thereby obtaining the trained machine learning model.
30. A method of determining, within a predetermined amount of time, a control setting for an actuator of an exposure apparatus based on a desired correction of a lithographic exposure process performed by the exposure apparatus, the method comprising:
   - determining an initial control setting for the actuator based on the desired correction of the lithographic exposure process by providing the desired correction of the lithographic exposure process as input to a trained machine learning model;
   - iteratively refining the initial control setting to approach the desired correction of the lithographic exposure process, thereby obtaining the control setting for the actuator, a number of iterative refinements constrained by the predetermined amount of time.
31. A method performed by an exposure apparatus comprising projecting a patterned beam of radiation onto a substrate, wherein a control setting for an actuator of the exposure apparatus is determined by a method according to clause 30.
32. A computer program comprising instructions to cause a computer or the control unit of the exposure apparatus according to any one of clauses 1-16 to perform the steps of the method according to clause 29.
33. A computer program comprising instructions to cause the control unit of the exposure apparatus according to any one of clauses 1-16 to perform the steps of the method according to clause 30 or clause 31.

## Claims

1. An exposure apparatus configured to perform a lithographic exposure process, comprising:
- an actuator;
- a control unit configured to control the actuator, the control unit comprising a trained machine learning model;
wherein the control unit is configured to determine, within a predetermined amount of time, a control setting for controlling the actuator by:
• obtaining a desired correction of the lithographic exposure process;
• determining an initial control setting for the actuator based on the desired correction of the lithographic exposure process;
• iteratively refining the initial control setting to approach the desired correction of the lithographic exposure process, thereby obtaining the control setting for the actuator, a number of iterative refinements constrained by the predetermined amount of time;
wherein the control unit is configured to determine the initial control setting for the actuator by providing the desired correction of the lithographic exposure process as input to the trained machine learning model.

2. The exposure apparatus according to claim 1, wherein the control unit is configured to control the actuator according to the obtained control setting.

3. The exposure apparatus according to any one of the preceding claims, wherein:
- the control unit further comprises a numerical solver for determining the control setting for the actuator based on a model of the exposure apparatus and a cost function which is based on the desired correction of the lithographic exposure process;
- the control unit is configured to iteratively refine the initial control setting by providing the initial control setting as an initial condition to the numerical solver; and
- the numerical solver is configured to refine the initial control setting by minimizing the cost function.

4. The exposure apparatus according to claim 3, wherein the control unit is further configured to:
- determine a configuration parameter for the numerical solver by providing the desired correction of the lithographic exposure process to the trained machine learning model;
- initialize the numerical solver with the configuration parameter.

5. The exposure apparatus according to any one of the preceding claims, wherein the control setting comprises a set-point for the actuator, and wherein the initial control setting for the actuator is an initial set-point for the actuator.

6. The exposure apparatus according to any one of the preceding claims, wherein the set-point for the actuator and the initial set-point for the actuator are a dynamically evolving quantity over time.

7. The exposure apparatus according to any one of the preceding claims, wherein the desired correction of the lithographic exposure process comprises one or more of reticle alignment control, reticle heating control, lens heating, wafer heating control, wafer alignment, aberration correction, and on-product overlay control.

8. The exposure apparatus according to any one of the preceding claims, wherein the exposure apparatus comprises a plurality of actuators, and wherein the control unit is configured to determine, within the predetermined amount of time, a control setting for controlling each of the actuators.

9. The exposure apparatus according to claim 8, wherein:
- the exposure apparatus comprises a projection system, the projection system comprising at least one optical element;
- the plurality of actuators comprises a projection system actuator; and
- the control unit is configured to control the projection system actuator to manipulate the orientation or deformation of the optical element based on the obtained control setting.

10. The exposure apparatus according to any one of the preceding claims, wherein the control unit is configured to:
• allocate a predetermined portion of the predetermined amount of time to perform the step of determining the initial control setting for the actuator, and
• allocate the remainder of the predetermined amount of time to perform the step of iteratively refining the initial control setting.

11. A control unit configured to control an actuator of a semiconductor manufacturing apparatus or semiconductor metrology apparatus configured to perform a process, the control unit comprising a trained machine learning model;
wherein the control unit is configured to determine, within a predetermined amount of time, a control setting for controlling the actuator by:
• obtaining a desired correction of the process performed by the semiconductor manufacturing apparatus or semiconductor metrology apparatus;
• determining an initial control setting for the actuator based on the desired correction of the process performed by the semiconductor manufacturing apparatus or semiconductor metrology apparatus;
• iteratively refining the initial control setting to approach the desired correction of the process performed by the semiconductor manufacturing apparatus or semiconductor metrology apparatus, thereby obtaining the control setting for the actuator, a number of iterative refinements constrained by the predetermined amount of time;
wherein the control unit is configured to determine the initial control setting for the actuator by providing the desired correction of the process performed by the semiconductor manufacturing apparatus or semiconductor metrology apparatus as input to the trained machine learning model.

12. A method of obtaining a trained machine learning model, the method comprising the following steps:
- collecting an input dataset comprising a plurality of desired corrections of a lithographic exposure process performed by an exposure apparatus;
- constructing an output dataset by, for each of desired correction of the lithographic exposure in the plurality of desired corrections of the lithographic exposure:
• determining an initial estimate of the control setting for an actuator of the lithographic exposure apparatus based on the desired correction of the lithographic exposure process;
• iteratively refining the initial control setting to approach the desired correction of the lithographic exposure process, thereby obtaining an optimal control setting for the actuator;
• adding the optimal control setting for the actuator to the output dataset;
- training a machine learning model using the input dataset and the output dataset, thereby obtaining the trained machine learning model.

13. A method of determining, within a predetermined amount of time, a control setting for an actuator of an exposure apparatus based on a desired correction of a lithographic exposure process performed by the exposure apparatus, the method comprising:
- determining an initial control setting for the actuator based on the desired correction of the lithographic exposure process by providing the desired correction of the lithographic exposure process as input to a trained machine learning model;
- iteratively refining the initial control setting to approach the desired correction of the lithographic exposure process, thereby obtaining the control setting for the actuator, a number of iterative refinements constrained by the predetermined amount of time.

14. A method performed by an exposure apparatus comprising projecting a patterned beam of radiation onto a substrate, wherein a control setting for an actuator of the exposure apparatus is determined by a method according to claim 13.

15. A computer program comprising instructions to cause a computer or the control unit of the exposure apparatus according to any one of claims 1-10 to perform the steps of the method according to claim 13.
